# FASCICULE DE BREVET EUROPEEN

(11) **EP 0 908 844 B1**
(45) Date de publication et mention de la délivrance du brevet: **09.12.2009**
(21) Numéro de dépôt: 98402473.7
(22) Date de dépôt: 06.10.1998
(51) Int. Cl.: G06K 19/077

(54) **Carte à microcircuit combinant des plages de contact extérieur et une antenne,et procédé de fabrication d'une telle carte**
Karte mit Mikroschaltung, welche die Strecken des externen Kontaktes und einer Antenne kombiniert und Herstellungsverfahren einer solchen Karte
Card with microcircuit combining the surfaces of external contact and an antenna and manufacturing process of such card

(30) Priorité: 07.10.1997 FR 9712491
(43) Date de publication de la demande: 14.04.1999
(73) Titulaire: OBERTHUR TECHNOLOGIES, 92300 Levallois-Perret (FR)
(72) Inventeur: Launay, François, 14610 Epron (FR)
(74) Mandataire: Santarelli

(56) Documents cités:
- EP-A- 0 671 705
- EP-A- 0 682 321
- EP-A- 0 723 244
- EP-A- 0 818 752
- EP-A- 1 014 301
- DE-A- 19 601 203

## Description

La présente invention concerne un dispositif de carte à microcircuit et un procédé de fabrication d'une telle carte. Il s'agit, plus précisément, d'une carte à microcircuit qui fonctionne à la fois grâce à des données transmises par des contacts ou grâce à des données transmises par une antenne, c'est-à-dire sans contact.

On connaît déjà une carte qui fonctionne à la fois grâce à des données transmises par des contacts ou grâce à des données transmises sans contacts. Le brevet européen EP 0 706 152 mentionne une telle carte. Elle est munie de deux microcircuits : l'un sert à l'utilisation de la carte par contacts, l'autre sert à l'utilisation de la carte sans contact, via une antenne. L'inconvénient d'une telle carte est le coût dû à l'emploi et au montage de deux microcircuits.

On connaît également une carte qui n'emploie qu'un seul microcircuit et qui fonctionne à la fois grâce à des données transmises par des contacts ou grâce à des données transmises sans contact. Le brevet US 5 598 032 décrit une telle carte. Elle présente un module qui supporte le microcircuit. Ce module est constitué de plages de contact extérieur séparées par des isolants et d'un microcircuit fixé dessus. Des connexions sont nécessaires entre le microcircuit et les plages de contact extérieur : elles sont généralement assurées par des fils. D'autres connexions du module réalisent la liaison du microcircuit à l'antenne. Un inconvénient d'une telle carte est lié au fait qu'un tel module peut être extrait sans destruction de son support et peut ainsi être réemployé frauduleusement. Un autre inconvénient provient de la complexité de la réalisation d'un module : ceci entraîne un coût élevé.

Un autre module, comportant des plages de contact extérieur et une antenne, est décrit dans le document EP-A-1 014 301 opposable au titre de l'article 54 (3) CBE. Il présente certains des inconvénients précités.

Quant au document EP-A-0 818 752, également opposable au titre de l'article 54 (3) CBE, il décrit un insert pour carte à puce comportant, sur une face, des plages de contact et, sur l'autre face, un microcircuit et une antenne disposée à distance et reliée par des pistes conductrices. Il présente certains des inconvénients précités.

L'invention a pour but de remédier à ces inconvénients. Elle améliore l'encastrement du microcircuit dans une carte pour empêcher un emploi frauduleux. L'invention permet de baisser le coût de réalisation d'une telle carte en disposant et en connectant directement le microcircuit sur la carte. Elle simplifie également la réalisation d'une carte. Ces avantages apparaîtront plus clairement au cours de la description qui suit.

Plus précisément l'invention concerne une carte à microcircuit selon la revendication 1.

Le support et la plaquette sont généralement constitués en matériau thermoplastique. La cavité précitée peut être réalisée dans le support ou dans la plaquette ou peut également être définie dans l'ensemble constitué par le support et la plaquette. Cette cavité peut être constituée par un espace entre le support et la plaquette. Cette cavité est destinée à loger un microcircuit. Ce microcircuit est muni d'extrémités de raccordement. Une antenne, munie de bornes de connexion, est disposée entre le support et la plaquette. Ceci permet de protéger l'antenne et d'éviter de la faire apparaître. Des plages de contact extérieur servent à recueillir les informations par contact. Ces plages de contact extérieur peuvent avantageusement être encastrées dans la carte, de façon inextractible. Elles sont reliées à des bornes de connexion, qui assurent les connexions des plages de contact extérieur au microcircuit. Le microcircuit est connecté à la fois à l'antenne, par l'intermédiaire des bornes de connexion de l'antenne, et aux plages de contact extérieur, par l'intermédiaire des bornes de connexion reliées aux plages de contact extérieur. Ces bornes de connexion sont disposées en vis-à-vis des extrémités de raccordement correspondantes du microcircuit et sont reliées aux extrémités de raccordement correspondantes du microcircuit. Cette particularité de montage permet d'éviter la réalisation d'un module ; on évite aussi des fils de connexion entre les plages de contact extérieur et les extrémités de raccordement. On connecte directement l'ensemble des bornes de connexion aux extrémités de raccordement correspondantes du microcircuit, éventuellement avec interposition d'excroissances conductrices comme on le verra plus loin.

L'antenne peut avoir diverses configurations. Il peut s'agir d'une bobine électromagnétique. Elle peut ainsi notamment comporter des spires : dans ce cas on peut faire passer l'antenne sous le microcircuit en définissant un regroupement des bornes de connexion reliées aux plages de contact extérieur en deux ensembles tels que les spires passent entre lesdits deux ensembles. Cette configuration permet d'éviter de faire passer une connexion de l'antenne par dessus les spires. Un resserrement des spires peut être nécessaire au niveau du passage des spires entre les deux ensembles de bornes de connexion. L'antenne peut, par exemple, être réalisée par estampage à chaud, ou par le dépôt d'un fil de matériau conducteur, ou par sérigraphie d'une encre conductrice ou d'une résine conductrice, ou par photogravure ou encore par tampographie. L'estampage à chaud est notamment décrit dans le brevet européen EP 0 063 347. Une rainure peut être agencée pour contenir l'antenne. Cette rainure peut être réalisée dans le support ou dans la plaquette ou dans l'ensemble constitué par le support et la plaquette.

Les plages de contact extérieur sont préférablement réalisées par estampage à chaud. Le plus souvent des pistes de connexion relient les plages de contact extérieur aux bornes de connexion respectives : dans ce cas les plages de contact extérieur, les bornes de connexion des plages de contact extérieur et les pistes de connexion peuvent être réalisées en même temps, par exemple par estampage à chaud.

Le microcircuit est fermement fixé, de façon inextractible, dans la cavité. Pour cela, le microcircuit est généralement collé. Une colle anisotrope peut être utilisée : elle permet en outre de faciliter la connexion entre les bornes de connexion et les extrémités de raccordement du microcircuit. Une colle isolante peut également être utilisée : elle permet de bien isoler les différents éléments conducteurs qui ne sont pas destinés à être connectés.

Une colle conductrice déposée sur au moins certaines extrémités de raccordement du microcircuit et/ou certaines bornes de connexion permet également de réaliser la fixation et la connexion du microcircuit.

Des excroissances conductrices peuvent être présentes sur au moins certaines des extrémités de raccordement du microcircuit et/ou sur certaines des bornes de connexion : elles permettent de faciliter la connexion entre les extrémités de raccordement du microcircuit et les bornes de connexion correspondantes. Lorsque de la colle isolante est utilisée, l'application avec une pression controlée du microcircuit permet de chasser la colle aux points de contact, notamment en présence d'excroissances conductrices : on obtient ainsi une bonne connexion entre les bornes de connexion et les extrémités de raccordement du microcircuit, éventuellement par l'intermédiaire d'excroissances conductrices. Lorsque de la colle anisotrope est utilisée, l'écrasement de la colle aux points de contact permet une bonne connexion électrique, notamment en présence d'excroissances conductrices. Ces excroissances conductrices sont réalisées en un matériau conducteur, par exemple en métal ou en colle conductrice. Une colle conductrice peut en outre être déposée sur au moins certaines excroissances conductrices, pour effectuer les connexions.

Une résine de protection disposée sur ou autour du microcircuit permet de protéger ce dernier.

Selon un mode de réalisation de l'invention, les plages de contact extérieur et les bornes de connexion desdites plages de contact extérieur peuvent être disposées sur la plaquette. Il peut être avantageux, notamment dans ce mode de réalisation d'utiliser deux ou plusieurs excroissances conductrices superposées entre des extrémités de raccordement et des bornes de connexion correspondantes : ceci facilite la connexion entre lesdites extrémités de raccordement et lesdites bornes de connexion correspondantes lorsque la distance entre ces éléments correspondants, qui doivent être connectés, est grande.

Selon un autre mode de réalisation, les plages de contact extérieur et l'antenne peuvent être disposées sur le support.

L'invention concerne également un procédé de réalisation d'une carte à microcircuit, selon la revendication 18.

On entend par "flip-chip", l'opération, connue en soi, décrite dans le brevet européen n° 0 688 051, qui consiste à fixer le microcircuit et à le connecter aux bornes de connexion correspondantes.

Selon une possibilité, l'antenne peut être déposée par estampage à chaud. Elle peut aussi être réalisée soit par le dépôt d'un fil de matériau conducteur soit par sérigraphie d'une encre conductrice ou d'une résine conductrice soit par photogravure, soit encore par tampographie.

Le procédé de réalisation peut comporter la réalisation d'une rainure sur le support ou dans la plaquette ou dans l'ensemble constitué par le support et la plaquette : cette rainure est destinée à loger l'antenne.

Au cours d'un estampage à chaud des surépaisseurs, dues notamment au fluage, sont susceptibles d'apparaître sur le support et/ou la plaquette : ces surépaisseurs peuvent être aplaties, par exemple à l'aide d'un outil plat.

Un procédé de réalisation particulier selon l'invention consiste à utiliser une colle qui présente un rétreint au durcissement : une telle colle permet d'améliorer les contacts entre les bornes de connexion et le microcircuit, notamment lorsque la carte est fléchie.

Selon un procédé de réalisation, les plages de contact extérieur et l'antenne peuvent être réalisées au cours de la même opération.

Le procédé peut comporter la réalisation d'excroissances conductrices. Ces dernières peuvent être réalisées par fusion thermosonique d'un fil métallique. Une telle fusion thermosonique est connue en soi.

Les dessins annexés illustrent, à titre d'exemple, l'invention.
La figure 1 représente, en vue de dessus, un exemple de réalisation d'une carte selon l'invention.
La figure 2 représente, en vue partielle de dessus, un grossissement de la zone qui contient le microcircuit sur la carte de la figure 1.
La figure 3 représente, en vue partielle de dessus, un grossissement de la même zone de la carte que la figure 2, sans que la résine de protection n'y soit représentée.
La figure 4 représente la coupe IV-IV de la figure 2.
La figure 5 représente la coupe V-V de la figure 2.
La figure 6 représente, en vue partielle de dessus, un grossissement de la même zone de la carte que la figure 2, sans que ni la résine de protection, ni le microcircuit n'y soient représentés.
La figure 7 représente en perspective un support muni d'une rainure dans laquelle une antenne est disposée.
Les figures 8 à 16 illustrent les étapes essentielles d'un exemple de procédé de réalisation d'une carte selon l'invention.
Les figures 17 à 21 illustrent un exemple de réalisation d'une carte selon l'invention.
Les figures 22 à 27 illustrent un autre exemple de réalisation d'une carte selon l'invention.

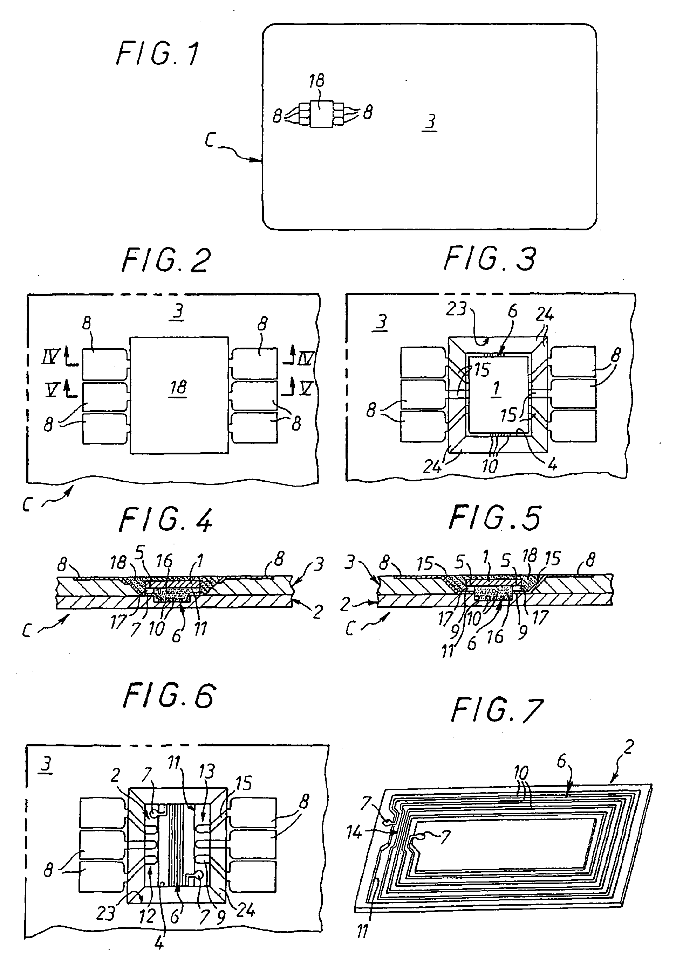

En référence aux figures 1 à 7 on va décrire un premier exemple de mode de réalisation d'une carte selon l'invention. Une telle carte C comporte un microcircuit 1, un support 2, une plaquette 3 fixée sur le support, une cavité 4 définie au moins en partie dans le support et/ou la plaquette. Dans l'exemple, la cavité est réalisée grâce à une fenêtre 23 découpée dans la plaquette. Le fond de la cavité est constitué par le support 2. Le microcircuit est muni d'extrémités de raccordement 5 et est disposé dans ladite cavité. Une antenne 6 munie de bornes de connexion 7, qui apparaissent au fond de la cavité, est disposée entre ledit support et ladite plaquette. Des plages de contact extérieur 8 sont reliées à des bornes de connexion 9, qui sont agencées au fond de la cavité. Le microcircuit est connecté à la fois à l'antenne et aux plages de contact extérieur. L'ensemble des bornes de connexion 7, 9 est disposé en vis-à-vis des extrémités de raccordement 5 correspondantes du microcircuit et sont reliées auxdites extrémités de raccordement correspondantes du microcircuit.

Dans la forme de réalisation des figures 1 à 7, l'antenne comporte des spires 10, déposées dans une rainure 11. On a prévu un regroupement des bornes de connexion des plages de contact extérieur en deux ensembles (respectivement 12 et 13) tel que les spires de l'antenne passent entre les deux ensembles. Cela est visible sur la figure 6 , où apparaissent, d'une part (à gauche des fragments de spires visibles), un ensemble 12 de trois bornes de connexion de plages de contact extérieur et, d'autre part (à la droite des fragments de spires visibles), un autre ensemble 13 de trois bornes de connexion des plages de contact extérieur.

Les spires de l'antenne présentent un resserrement 14 au niveau de leur passage entre lesdits deux ensembles. Le support présente une rainure 11 et l'antenne est disposée dans ladite rainure. Les plages de contact extérieur 8 sont reliées aux bornes de connexion respectives 9 par des pistes de connexion 15, qui s'étendent sur des flancs inclinés 24 de la fenêtre. Le microcircuit est fixé par une colle isolante 16. Il présente des excroissances conductrices 17 sur toutes ses extrémités de raccordement. Une résine de protection 18 enrobe et protège le microcircuit. La résine de protection et la colle peuvent éventuellement être de même nature.

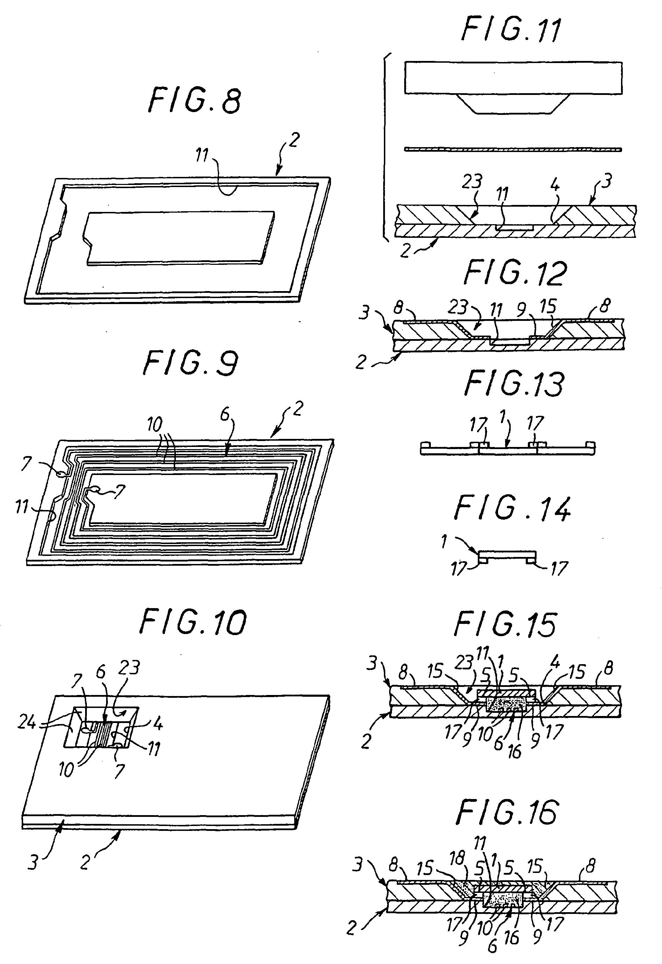

En référence aux figures 8 à 16, on va maintenant décrire un exemple de procédé de réalisation d'une carte conforme aux figures 1 à 7.

On usine une rainure 11 dans un support. On peut également utiliser directement un support muni d'une rainure, produit par exemple en plastique moulé, comme cela est montré sur la figure 8. On dépose une antenne dans la rainure : la figure 9 montre le résultat de cette opération. Cette antenne peut être déposée par exemple par estampage à chaud sur le support. Elle peut également être déposée, soit par sérigraphie d'une encre conductrice ou d'une résine conductrice, soit par photogravure, soit encore par tampographie. Elle peut aussi être réalisée par le dépôt d'un fil de matériau conducteur. On fixe ensuite une plaquette sur le support : cette plaquette est munie d'une fenêtre qui laisse apparaître les bornes de connexion de l'antenne (figure 10). La figure 11 montre en coupe et de façon schématique comment les plages de contact extérieur, les bornes de connexion des plages de contact extérieur et les pistes de connexion reliant les plages de contact extérieur aux bornes de connexion des plages de contact extérieur sont réalisées par estampage à chaud en une opération. La figure 12 illustre, en vue de coupe, le résultat d'un tel estampage à chaud. Indépendemment de cette opération, on dépose des excroissances conductrices 17, couramment appelés "bumps" dans la technique, sur les extrémités de raccordement de microcircuits. Comme on le sait, plusieurs microcircuits identiques sont définis sur un même substrat ou "wafer". Le découpage final de ce substrat individualise les microcircuits. Les excroissances conductrices sont réalisées sur chaque microcircuit avant la fragmentation du substrat. C'est ce qu'illustre schématiquement, la figure 13 où une partie du substrat est représentée en coupe avant le découpage de celui-ci, chaque microcircuit comportant déjà ses excroissances. Après le découpage (classique et non représenté) qui individualise les microcircuits, l'un d'eux (figure 14) est prélevé et retourné dans la cavité pour y être fixé et raccordé aux bornes de connexion (figure 15) : c'est l'opération de "flip-chip". Les bornes de connexion sont disposées de telle sorte qu'elles correspondent respectivement aux connexions définies sur le microcircuit. Sur les figures 14 et 15 on dépose de la colle dans la cavité et on dispose le microcircuit dans la cavité. On peut aussi évidemment enduire le microcircuit de colle puis le coller dans la cavité. Dans un mode préféré de réalisation, on utilise de la colle qui présente un rétreint au durcissement pour coller le microcircuit : en effet les excroissances conductrices disposées sur les extrémités de raccordement du microcircuit sont alors appliquées avec force contre les bornes de connexion, ceci améliore le contact électrique. On dépose ensuite de la résine de protection dans la cavité. Le résultat de cette opération est représenté, en coupe, sur la figure 16.

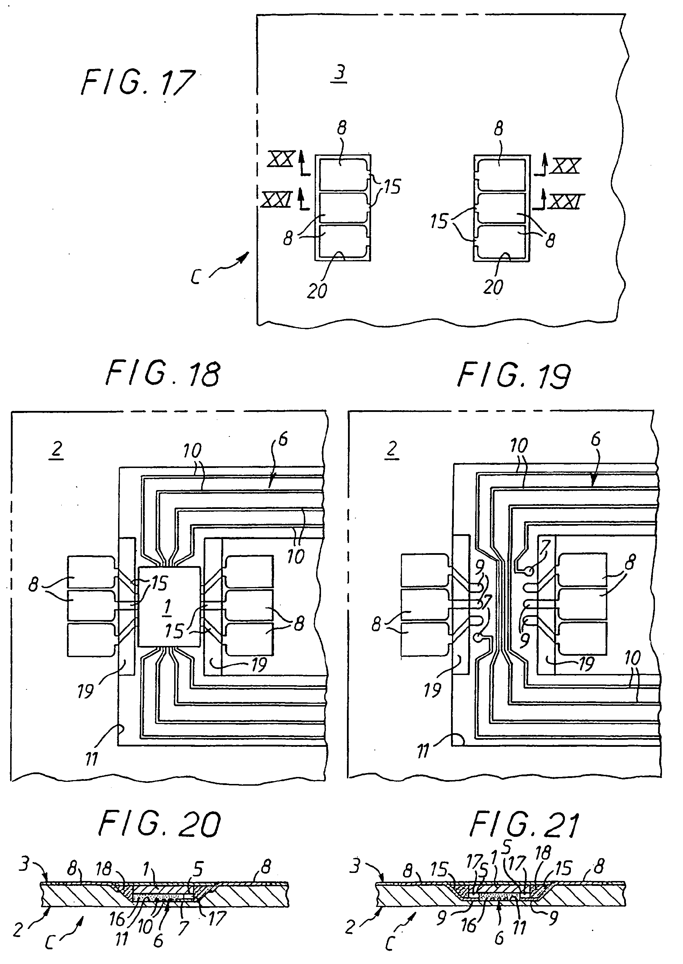

Sur les figures 17 à 21, on a illustré un autre mode de réalisation d'une carte selon l'invention. La figure 17 représente en vue partielle de dessus une carte selon ce mode de réalisation. Deux fenêtres 20 disposées dans la plaquette permettent l'accès aux plages de contact extérieur de la carte.

La figure 18 montre en vue partielle de dessus la carte, où l'on a oté la plaquette ainsi que la résine de protection.

La figure 19 montre le support en vue partielle de dessus. Une rainure 11 est présente dans ce support. L'antenne est disposée dans cette rainure. Les plages de contact extérieur sont disposées sur la surface supérieure du support près de la cavité. Les bornes de connexion sont toutes disposées au fond de la rainure. Cette rainure présente des flancs inclinés 19 : les pistes de connexion s'étendent sur le contour de ces flancs inclinés. On peut évidemment imaginer des variantes sans sortir du cadre de la présente invention : par exemple, les flancs inclinés peuvent être absents du bord de la rainure ou être présents sur tout ou partie du bord de la rainure. Un avantage de ce mode de réalisation provient du fait que l'on peut réaliser en une seule opération à la fois l'antenne, munie de ses bornes de connexion, ainsi que l'ensemble constitué par les plages de contact extérieur, les bornes de connexion des plages de contact extérieur et les pistes de connexion reliant les plages de contact extérieur aux bornes de connexion des plages de contact extérieur. Tous ces éléments peuvent par exemple être réalisés par estampage à chaud.

Les figures 20 et 21 sont des coupes partielles de la carte selon ce mode de réalisation.

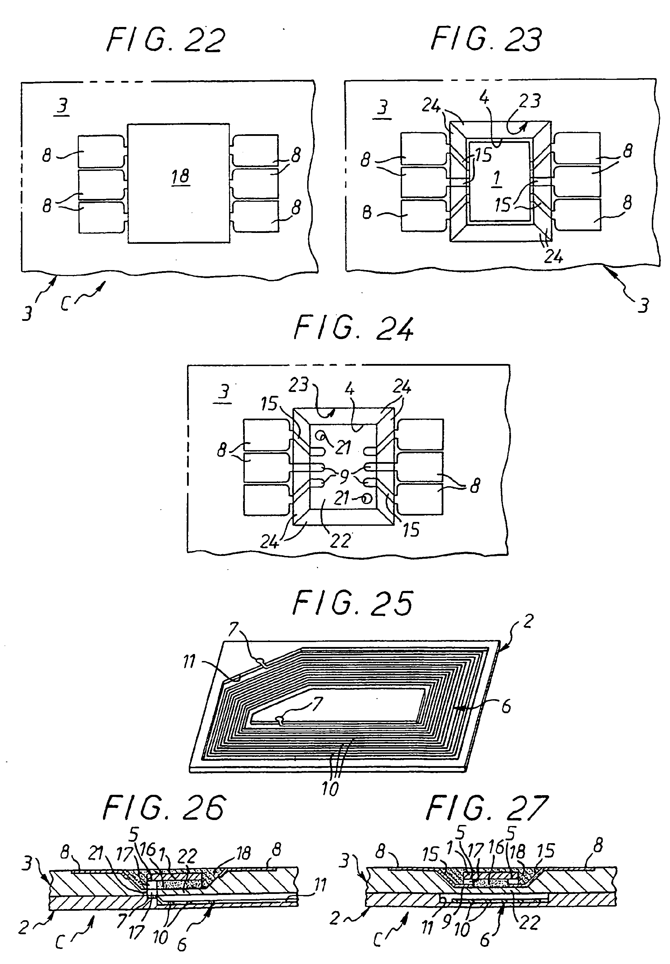

Sur les figures 22 à 27, on a illustré encore un autre mode de réalisation d'une carte selon l'invention.

La figure 22 représente en vue partielle de dessus la carte selon cet exemple de mode de réalisation.

La figure 23 représente en vue partielle de dessus la carte selon cet exemple de mode de réalisation sans que la résine de protection ne soit représentée.

La figure 24 est une vue partielle de dessus de la carte selon ce mode de réalisation sans que, ni la résine de protection, ni le microcircuit ne soient représentés. La plaquette est munie d'une cavité 4 : cette cavité présente un fond 22 qui fait partie de la plaquette. Deux orifices 21 sont ménagés à travers le fond de la cavité. Ces orifices permettent la connexion entre le microcircuit et l'antenne, cette dernière étant située entre le support et la plaquette.

La figure 26 est une vue partielle en coupe de la carte selon cet exemple de mode de réalisation. On y voit notamment le fond 22 de la cavité, ainsi qu'un des orifices 21 disposé dans le fond de cette cavité. Deux excroissances conductrices 17 sont superposées pour permettre la connexion entre l'antenne et le microcircuit. Dans un mode préféré de réalisation, l'excroissance conductrice liée à l'antenne est réalisée par le dépôt d'une goutte de colle conductrice alors que l'excroissance conductrice liée au microcircuit est réalisée par fusion thermosonique d'un fil métallique. On peut ainsi, par exemple, déposer une goutte de colle conductrice à l'intérieur des orifices 21, après que la plaquette ait été déposée sur le support muni de l'antenne. Les bornes de connexion de l'antenne sont surélevées par rapport à la rainure pour faciliter la connexion entre l'antenne et le microcircuit.

La figure 27 est une vue partielle en coupe, de la carte selon ce mode de réalisation. Le fond de la plaquette isole l'antenne du microcircuit, c'est un des avantages lié à ce mode de réalisation. Un autre avantage provient du fait que l'on peut réaliser de façon indépendante, d'une part, l'antenne sur le support et, d'autre part, la plaquette avec les plages de contact extérieur, les bornes de connexion de l'antenne et les pistes de connexion reliant les plages de contact extérieur aux bornes de connexion des plages de contact extérieur.

La figure 25 représente en perspective le support muni d'une rainure dans laquelle est disposée une antenne. Elle illustre encore un avantage de ce mode de réalisation : on dispose de plus de place en largeur pour faire passer l'antenne sous le microcircuit, ceci est d'autant plus accentué que les extrémités de raccordement destinées à la connexion de l'antenne sont disposées à des coins opposés du microcircuit.

## Revendications

1. Carte à microcircuit comprenant
- un support (2),
- une plaquette (3) fixée sur le support,
- une cavité (4) définie au moins en partie dans le support et/ou la plaquette,
- un microcircuit (1) muni d'extrémités de raccordement (5) et disposé dans ladite cavité,
- une antenne (6) munie de bornes de connexion (7), agencées au fond de la cavité, et l'antenne étant disposée entre ledit support et ladite plaquette,
- et des plages de contact extérieur (8) reliées à d'autres bornes de connexions (9), lesdites autres bornes de connexion étant agencées au fond de la cavité,
et dans laquelle :
■ ledit microcircuit est connecté à la fois à l'antenne et aux plages de contact extérieur,
■ les bornes de connexion précitées (7, 9) sont disposées en vis-à-vis des extrémités de raccordement correspondantes du microcircuit et y sont respectivement connectées, et
■ le microcircuit est ainsi entre le fond de cette cavité et la face de la carte portant les plages de contact extérieur.

2. Carte à microcircuit selon la revendication 1, **caractérisée en ce que** les plages de contact extérieur sont disposées près de la cavité et sont reliées à leurs bornes de connexion par des pistes de connexion s'étendant sur des flancs inclinés de cette cavité.

3. Carte à microcircuit selon la revendication 1 ou la revendication 2, **caractérisée en ce que** l'antenne passe sous le microcircuit.

4. Carte à microcircuit selon l'une quelconque des revendications 1 à 3, **caractérisée en ce que** des orifices (21) ménagés à travers le fond de la cavité permettent la connexion entre le microcircuit et l'antenne.

5. Carte à microcircuit selon l'une quelconque des revendications 1 à 4, **caractérisée en ce que** l'antenne comporte des spires (10) et **en ce qu'**il existe un regroupement des bornes de connexion des plages de contact extérieur en deux ensembles tel que les spires passent entre lesdits deux ensembles.

6. Carte à microcircuit selon l'une quelconque des revendications 1 à 3, **caractérisée en ce que** l'antenne comporte des spires (10), il existe un regroupement des bornes de connexion des plages de contact extérieur en deux ensembles tels que les spires passent entre lesdits deux ensembles, et les spires de l'antenne présentent un resserrement au niveau de leur passage entre lesdits deux ensembles.

7. Carte à microcircuit selon l'une quelconque des revendications précédentes, **caractérisée en ce qu'**une rainure (11) est présente dans le support et/ou dans la plaquette et **en ce que** l'antenne est disposée dans ladite rainure.

8. Carte à microcircuit selon l'une quelconque des revendications précédentes, dans laquelle les plages de contact extérieur sont reliées aux bornes de connexion (15), **caractérisée en ce que** les plages de contact extérieur, les bornes de connexion des plages de contact extérieur et lesdites pistes de connexion sont réalisées par estampage à chaud.

9. Carte à microcircuit selon l'une quelconque des revendications précédentes, **caractérisée en ce que** le microcircuit est fixé par une colle anisotrope.

10. Carte à microcircuit selon l'une quelconque des revendications 1 à 8, **caractérisée en ce que** le microcircuit est fixé par une colle isolante.

11. Carte à microcircuit, selon l'une quelconque des revendications précédentes, **caractérisé en ce que** le microcircuit présente des excroissances conductrices (17) sur un ensemble des extrémités de raccordement du microcircuit et/ou sur un ensemble des bornes de connexion.

12. Carte à microcircuit selon la revendication 11, **caractérisée en ce que** les excroissances conductrices sont réalisées en métal ou en colle conductrice.

13. Carte à microcircuit selon l'une quelconque des revendications 11 ou 12, **caractérisée en ce que** le microcircuit est fixé par une colle conductrice déposée sur un ensemble des excroissances conductrices et/ou sur un ensemble des extrémités de raccordement du microcircuit et/ou sur un ensemble des bornes de connexion.

14. Carte à microcircuit selon l'une quelconque des revendications précédentes, **caractérisée en ce que** les plages de contact extérieur et les bornes de connexion desdites plages de contact extérieur sont disposées sur la plaquette.

15. Carte à microcircuit selon l'une quelconque des revendications précédentes, **caractérisée en ce que** deux ou plusieurs excroissances conductrices superposées sont présentes sur un ensemble d'extrémités de raccordement du microcircuit et/ou un ensemble de bornes de connexion.

16. Carte à microcircuit selon l'une quelconque des revendications 1 à 13, **caractérisée en ce que** les plages de contact extérieur et l'antenne sont sur le support et **en ce que** la plaquette est conformée pour permettre l'accès aux plages de contact extérieur.

17. Carte à microcircuit selon l'une quelconque des revendications précédentes, **caractérisée en ce qu'**une résine (18) protège le microcircuit.

18. Procédé de réalisation d'une carte à microcircuit, ledit microcircuit étant muni d'extrémités de raccordement, le procédé comprenant la réalisation d'une structure constituée
- par un support (2),
- par une plaquette (3) fixée sur le support,
- par une antenne (6) munie de bornes de connexion (7) et disposée entre le support et ladite plaquette, et
- par une cavité (4) définie au moins en partie dans le support et/ou la plaquette,
ce procédé étant tel que :
■ il comprend la réalisation de plages de contact extérieur (8) reliées à des bornes de connexion (9),
■ on réalise au fond de la cavité les bornes de connexion (9) auxquelles les plages de contact extérieur (8) sont reliées,
■ l'antenne (6) est disposée de telle sorte que les bornes de connexion dont elle est munie sont au fond de la cavité,
■ l'ensemble des bornes de connexion étant agencé selon une configuration correspondant à celle des extrémités de raccordement (5) d'un microcircuit telle que les bornes de connexion précitées (7, 9) puissent être disposées en vis-à-vis des extrémités de raccordement correspondantes de ce microcircuit, et
■ il comprend une étape consistant à disposer et à connecter ledit microcircuit par montage dit « flip-chip » aux bornes de connexion de l'antenne et des plages de contact extérieur, en sorte d'être situé entre le fond de cette cavité et la face de la carte sur laquelle les plages de contact extérieur sont réalisées.

19. Procédé selon la revendication 18, **caractérisé en ce qu'**on dispose les plages de contact extérieur à leurs bornes de connexion par des pistes de connexion s'étendant sur des flancs inclinés de cette cavité.

20. Procédé de réalisation d'une carte à microcircuit selon la revendication 18 ou de la revendication 19, **caractérisé en ce que** l'on fait passer l'antenne sous le microcircuit.

21. Procédé de réalisation d'une carte à microcircuit selon l'une quelconque des revendications 18 à 20, **caractérisé en ce que** l'on connecte le microcircuit aux bornes de connexion de l'antenne au travers du fond de la cavité.

22. Procédé de réalisation d'une carte à microcircuit selon l'une quelconque des revendications 18 à 21, **caractérisé en ce qu'**on dépose l'antenne par estampage à chaud.

23. Procédé de réalisation d'une carte à microcircuit selon l'une quelconque des revendications 18 à 21, **caractérisé en ce qu'**on réalise l'antenne soit par dépôt d'un fil de matériau conducteur soit par sérigraphie d'une encre conductrice ou d'une résine conductrice soit par photogravure soit par tampographie.

24. Procédé de réalisation d'une carte à microcircuit selon l'une quelconque des revendications 18 à 23, les plages de contact extérieur étant reliées aux bornes de connexion respectives par des pistes de connexion, **caractérisé en ce que** les plages de contact extérieur, les bornes de connexion des plages de contact extérieur, et lesdites pistes de connexion sont réalisées par estampage à chaud.

25. Procédé de réalisation d'une carte à microcircuit selon l'une quelconque des revendications 18 à 24, **caractérisé en ce qu'**on colle le microcircuit.

26. Procédé de réalisation d'une carte à microcircuit selon la revendication 25, **caractérisé en ce qu'**on utilise une colle qui présente un rétreint au durcissement pour coller le microcircuit tout en renforçant les contacts électriques au niveau des connexions entre le microcircuit d'une part, et les plages de contact extérieur et l'antenne d'autre part.

27. Procédé de réalisation d'une carte à microcircuit selon la revendication 25 ou 26, **caractérisé en ce qu'**on utilise une colle anisotrope pour coller le microcircuit.

28. Procédé de réalisation d'une carte à microcircuit selon la revendication 25 ou 26, **caractérisé en ce qu'**on utilise une colle isolante pour coller le microcircuit.

29. Procédé de réalisation d'une carte à microcircuit selon l'une quelconque des revendications 18 à 28, **caractérisé en ce qu'**on réalise des excroissances conductrices sur un ensemble des extrémités de raccordement du microcircuit et/ou sur un ensemble des bornes de connexion.

30. Procédé de réalisation d'une carte à microcircuit selon la revendication 29, **caractérisé en ce qu'**on réalise lesdites excroissances conductrices par fusion thermosonique d'un fil métallique.

31. Procédé de réalisation d'une carte à microcircuit selon la revendication 29, **caractérisé en ce qu'**on réalise lesdites excroissances conductrices par dépôt d'une colle conductrice.

32. Procédé de réalisation d'une carte à microcircuit selon l'une quelconque des revendications 29 à 31, **caractérisé en ce qu'**on dépose une colle conductrice sur un ensemble d'excroissances conductrices et/ou sur un ensemble des bornes de connexion et/ou sur un ensemble d'extrémités de raccordement pour coller le microcircuit.

33. Procédé de réalisation d'une carte à microcircuit selon l'une quelconque des revendications 18 à 32, **caractérisé en ce que** l'antenne et les plages de contact extérieur sont réalisées au cours de la même opération.

## Claims

1. Microcircuit card comprising
- a support (2),
- a plaquette (3) fixed to the support,
- a cavity (4) defined at least in part in the support and/or the plaquette,
- a microcircuit (1) provided with connecting leads (5) and disposed in said cavity,
- an antenna (6) provided with connection terminals (7), arranged at the bottom of the cavity, and the antenna being disposed between said support and said plaquette,
- and external contact zones (8) connected to other connection terminals (9), said other connection terminals being arranged at the bottom of the cavity,
and wherein:
■ said microcircuit is connected both to the antenna and to the external contact zones,
■ the aforementioned connection terminals (7, 9) are disposed facing the corresponding connecting leads of the microcircuit and are respectively connected thereto, and
■ the microcircuit is thus between the bottom of this cavity and the face of the card carrying the external contact zones.

2. Microcircuit card according to claim 1, **characterised in that** the external contact zones are disposed near the cavity and are connected to their connection terminals by connection tracks on inclined flanks of said cavity.

3. Microcircuit card according to claim 1 or claim 2, **characterised in that** the antenna passes under the microcircuit.

4. Microcircuit card according to any of claims 1 to 3, **characterised in that** orifices (21) produced through the bottom of the cavity enable the connection between the microcircuit and the antenna.

5. Microcircuit card according to any of claims 1 to 4, **characterised in that** the antenna includes turns (10) and **in that** there exists a grouping of the connection terminals of the external contact zones into two sets such that the turns pass between said two sets.

6. Microcircuit card according to any of claims 1 to 3, **characterised in that** the antenna includes turns (10), there exists a grouping of the connection terminals of the external contact zones in two sets such that the turns pass between said two sets, and the turns of the antenna are closer together where they pass between said two sets.

7. Microcircuit card according to any of the preceding claims, **characterised in that** a groove (11) is present in the support and/or in the plaquette and **in that** the antenna is disposed in said groove.

8. Microcircuit card according to any of the preceding claims, wherein the external contact zones are connected to the connection terminal (15), **characterised in that** the external contact zones, the connection terminals of the external contact zones and said connection tracks are produced by hot stamping.

9. Microcircuit card according to any of the preceding claims, **characterised in that** the microcircuit is fixed by an anisotropic glue.

10. Microcircuit card according to any of claims 1 to 8, **characterised in that** the microcircuit is fixed by an insulative glue.

11. Microcircuit card according to any of the preceding claims, **characterised in that** the microcircuit features conductive excrescences (17) over a set of the connecting leads of the microcircuit and/or over a set of the connection terminals.

12. Microcircuit card according to claim 11, **characterised in that** the conductive excrescences are produced in metal or in conductive glue.

13. Microcircuit card according to either of claims 11 or 12, **characterised in that** the microcircuit is fixed by a conductive glue deposited on a set of the conductive excrescences and/or on a set of the connecting leads of the microcircuit and/or a set of the connection terminals.

14. Microcircuit card according to any of the preceding claims, **characterised in that** the external contact zones and the connection terminals of said external contact zones are disposed on the plaquette.

15. Microcircuit card according to any of the preceding claims, **characterised in that** two or more superposed conductive excrescences are present on a set of connecting leads of the microcircuit and/or a set of connection terminals.

16. Microcircuit card according to any of claims 1 to 13, **characterised in that** the external contact zones and the antenna are on the support and **in that** the plaquette is conformed to allow access to the external contact zones.

17. Microcircuit card according to any of the preceding claims, **characterised in that** a resin (18) protects the microcircuit.

18. Method of producing a microcircuit card, said microcircuit card being provided with connecting leads, the method comprising the production of a structure consisting of
- a support (2),
- a plaquette (3) fixed to the support,
- an antenna (6) provided with connection terminals (7) and disposed between the support and said plaquette, and
- a cavity (4) defined at least in part in the support and/or the plaquette,
this method being such that:
■ it comprises the production of external contact zones (8) connected to connection terminals (9),
■ there are produced at the bottom of the cavity the connection terminals (9) to which the external contact zones (8) are connected,
■ the antenna (6) is disposed so that the connection terminals with which it is provided are at the bottom of the cavity,
■ all the connection terminals being arranged in a configuration corresponding to that of the connecting leads (5) of a microcircuit such that the aforementioned connection terminals (7, 9) can be disposed facing the corresponding connecting leads of this microcircuit, and
■ it comprises a step consisting of disposing and connecting said microcircuit by the so-called "flip-chip" method to the connection terminals of the antenna and the external contact zones, so as to be situated between the bottom of this cavity and the face of the card on which the external contact zones are produced.

19. Method according to claim 18, **characterised in that** the external contact zones are disposed to their connection terminals by connection tracks on inclined flanks of this cavity.

20. Method according to claim 18 or claim 19 of producing a microcircuit card, **characterised in that** the antenna is passed under the microcircuit.

21. Method according to any of claims 18 to 20 of producing a microcircuit card, **characterised in that** the microcircuit is connected to the connection terminals of the antenna through the bottom of the cavity.

22. Method according to any of claims 18 to 21 of producing a microcircuit card, **characterised in that** the antenna is deposited by hot stamping.

23. Method according to any of claims 18 to 21 of producing a microcircuit card, **characterised in that** the antenna is produced either by deposition of a conductive material wire or by screen prinking a conductive ink or a conductive resin or by photogravure or by stamping.

24. Method according to any of claims 18 to 23 of producing a microcircuit card, the external contact zones being connected to the respective connection terminals by connection tracks, **characterised in that** the external contact zones, the connection terminals of the external contact zones, and said connection tracks are produced by hot stamping.

25. Method according to any of claims 18 to 24 of producing a microcircuit card, **characterised in that** the microcircuit is glued.

26. Method according to claim 25 of producing a microcircuit card, **characterised in that** a glue is used that shrinks on hardening to glue the microcircuit at the same time as reinforcing the electrical contacts at the level of the connections between the microcircuit, on the one hand, and the external contact zones and the antenna, on the other hand.

27. Method according to claim 25 or 26 of producing a microcircuit card, **characterised in that** an anisotropic glue is used for gluing the microcircuit.

28. Method according to claim 25 or 26 of producing a microcircuit card, **characterised in that** an insulative glue is used for gluing the microcircuit.

29. Method according to any of claims 18 to 28 of producing a microcircuit card, **characterised in that** the conductive excrescences are produced on a set of the connecting leads of the microcircuit and/or on a set of the connection terminals.

30. Method according to claim 29 of producing a microcircuit card, **characterised in that** said conductive excrescences are produced by thermosonically melting a metal wire.

31. Method according to claim 29 of producing a microcircuit card, **characterised in that** said conductive excrescences are produced by depositing a conductive glue.

32. Method according to any of claims 29 to 31 of producing a microcircuit card, **characterised in that** a conductive glue is deposited on a set of conductive excrescences and/or on a set of the connection terminals and/or on a set of connecting leads to glue the microcircuit.

33. Method according to any of claims 18 to 32 of producing a microcircuit card, **characterised in that** the antenna and the external contact zones are produced during the same operation.

## Patentansprüche

1. Karte mit Mikroschaltung, umfassend
- einen Träger (2),
- eine Platte bzw. Leiterplatte (3), welche an dem Träger festgelegt ist,
- einen Hohlraum (4), welcher in wenigstens einem Teil in dem Träger und/oder der Platte definiert ist,
- eine Mikroschaltung (1), welche mit Anschlußenden (5) versehen und in dem Hohlraum angeordnet ist,
- eine Antenne (6), welche mit Verbindungspolen bzw. -klemmen (7) versehen ist, welche im Boden des Hohlraums ausgebildet sind, und wobei die Antenne zwischen dem Träger und der Platte angeordnet ist,
- und Strecken bzw. Bahnen eines äußeren Kontakts (8), welche mit anderen Verbindungsklemmen (9) verbunden sind, wobei die anderen Verbindungsklemmen am Boden des Hohlraums angeordnet sind,
und in welcher:
■ die Mikroschaltung gleichzeitig mit der Antenne und den Strecken des externen Kontakts verbunden ist,
■ die oben genannten Anschluß- bzw. Verbindungsklemmen (7, 9) gegenüber den entsprechenden Anschlußenden der Mikroschaltung angeordnet sind und jeweils damit verbunden sind, und
■ die Mikroschaltung sich somit zwischen dem Boden des Hohlraums und der Fläche bzw. Seite der Karte befindet, welche die Strecken des externen Kontakts trägt.

2. Karte mit Mikroschaltung nach Anspruch 1, **dadurch gekennzeichnet, daß** die Strecken des externen Kontakts nahe dem Hohlraum angeordnet sind und an ihren Verbindungsklemmen durch Verbindungsbahnen verbunden sind, welche sich über geneigte Flanken des Hohlraums erstrecken.

3. Karte mit Mikroschaltung nach Anspruch 1 oder Anspruch 2, **dadurch gekennzeichnet, daß** die Antenne unter der Mikroschaltung durchtritt bzw. verläuft.

4. Karte mit Mikroschaltung nach einem der Ansprüche 1 bis 3, **dadurch gekennzeichnet, daß** Öffnungen (21), welche durch den Boden des Hohlraums hergestellt bzw. ausgebildet sind, die Verbindung zwischen der Mikroschaltung und der Antenne erlauben.

5. Karte mit Mikroschaltung nach einem der Ansprüche 1 bis 4, **dadurch gekennzeichnet, daß** die Antenne Gänge bzw. Windungen (10) beinhaltet und daß eine Neuanordnung bzw. -gruppierung der Verbindungsklemmen der Strecken des externen Kontakts in zwei Einheiten vorliegt, so daß die Windungen zwischen den zwei Einheiten durchtreten.

6. Karte mit Mikroschaltung nach einem der Ansprüche 1 bis 3, **dadurch gekennzeichnet, daß** die Antenne Gänge bzw. Windungen (10) umfaßt, daß eine Neuanordnung der Verbindungsklemmen der Strecken des externen Kontakts in zwei Einheiten vorliegt, so daß die Windungen zwischen den zwei Einheiten durchtreten, und daß die Windungen der Antenne eine Spurverengung bzw. -verstärkung auf Höhe ihres Durchtritts zwischen den zwei Einheiten aufweisen.

7. Karte mit Mikroschaltung nach einem der vorangehenden Ansprüche, **dadurch gekennzeichnet, daß** eine Rille bzw. Nut (11) in dem Träger und/oder in der Platte vorhanden ist und daß die Antenne in der Rille angeordnet ist.

8. Karte mit Mikroschaltung nach einem der vorangehenden Ansprüche, in welcher die Strecken des externen Kontakts mit verbindungsklemmen bzw. -polen (15) verbunden sind, **dadurch gekennzeichnet, daß** die Strecken des externen Kontakts, die Verbindungsklemmen der Strecken des externen Kontakts und die Verbindungsbahnen durch eine Heiß- bzw. Warmprägung hergestellt sind.

9. Karte mit Mikroschaltung nach einem der vorangehenden Ansprüche, **dadurch gekennzeichnet, daß** die Mikroschaltung durch einen anisotropen Kleber festgelegt ist.

10. Karte mit Mikroschaltung nach einem der Ansprüche 1 bis 8, **dadurch gekennzeichnet, daß** die Mikroschaltung durch einen isolierenden Kleber festgelegt ist.

11. Karte mit Mikroschaltung nach einem der vorangehenden Ansprüche, **dadurch gekennzeichnet, daß** die Mikroschaltung leitende Erhebungen (17) auf einer Einheit von Verbindungsenden der Mikroschaltung und/oder auf einer Einheit der Verbindungsklemmen aufweist.

12. Karte mit Mikroschaltung nach Anspruch 11, **dadurch gekennzeichnet, daß** die leitenden Erhebungen aus Metall oder einem leitenden Kleber hergestellt bzw, ausgebildet sind.

13. Karte mit Mikroschaltung nach einem der Ansprüche 11 oder 12, **dadurch gekennzeichnet, daß** die Mikroschaltung durch einen leitenden Kleber festgelegt ist, welcher an einer Einheit der leitenden Erhebungen und/oder an einer Einheit der Verbindungsenden der Mikroschaltung und/oder an einer Einheit der Verbindungsklemmen angeordnet ist.

14. Karte mit Mikroschaltung nach einem der vorangehenden Ansprüche, **dadurch gekennzeichnet, daß** die Strecken des externen Kontakts und die Verbindungsklemmen der Strecken des externen Kontakts auf der Platte angeordnet sind.

15. Karte mit Mikroschaltung nach einem der vorangehenden Ansprüche, **dadurch gekennzeichnet, daß** zwei oder mehrere übereinander angeordnete leitende Erhebungen an einer Einheit von Anschlußenden der Mikroschaltung und/oder einer Einheit von Verbindungsklemmen vorhanden sind.

16. Karte mit Mikroschaltung nach einem der Ansprüche 1 bis 13, **dadurch gekennzeichnet, daß** die Strecken des externen Kontakts und die Antenne auf dem Träger vorliegen und daß die Platte entsprechend ausgebildet ist, um den Zutritt zu den Strecken des externen Kontakts zu erlauben.

17. Karte mit Mikroschaltung nach einem der vorangehenden Ansprüche, **dadurch gekennzeichnet, daß** ein Harz (18) die Mikroschaltung schützt.

18. Verfahren zur Herstellung einer Karte mit Mikroschaltung, wobei die Mikroschaltung mit Anschlußenden ausgebildet wird, wobei das Verfahren die Herstellung einer Struktur umfaßt, bestehend aus
- einem Support bzw. Träger (2),
- einer Platte bzw. Leiterplatte (3), welche an dem Träger festgelegt wird,
- einer Antenne (6), welche mit Verbindungspolen bzw. -klemmen (7) ausgebildet und zwischen dem Träger und der Platte angeordnet wird, und
- einem Hohlraum (4), welcher auf wenigstens einem Teil in dem Träger und/oder der Platte definiert wird,
wobei das Verfahren derart ist, daß:
■ es die Herstellung von Strecken eines externen Kontakts (8) umfaßt, welche mit Verbindungsklemmen bzw. -polen (9) verbunden werden,
■ am Boden des Hohlraums die Verbindungs- bzw. Anschlußklemmen (9) ausgebildet werden, mit welchen die Strecken des externen Kontakts (8) verbunden werden,
■ die Antenne (6) derart angeordnet wird, daß sich die Verbindungsklemmen, mit welchen sie ausgebildet wird, auf dem Boden des Hohlraums befinden,
■ die Einheit der Verbindungsklemmen gemäß einer Konfiguration entsprechend derjenigen von Anschlußenden (5) einer Mikroschaltung ausgebildet wird, so daß die oben genannten Verbindungsklemmen (7, 9) gegenüber den entsprechend den Anschlußenden der Mikroschaltung angeordnet werden können, und
■ es einen Schritt umfaßt, bestehend aus einem Anordnen und Verbinden der Mikroschaltung durch eine sogenannte "Flip-chip"-Montage mit den Verbindungsklemmen der Antenne und den Strecken des externen Kontakts derart, daß sie zwischen dem Boden des Hohlraums und der Fläche bzw. Seite der Karte angeordnet wird, auf welcher die Strecken des externen Kontakts ausgebildet werden.

19. Verfahren nach Anspruch 18, **dadurch gekennzeichnet, daß** die Strecken des externen Kontakts an ihren Verbindungsklemmen durch Verbindungsbahnen angeordnet werden, welche sich an geneigten Flanken des Hohlraums erstrecken.

20. Verfahren zur Herstellung einer Karte mit Mikroschaltung nach Anspruch 18 oder Anspruch 19, **dadurch gekennzeichnet, daß** die Antenne unter der Mikroschaltung hindurchgeführt wird.

21. Verfahren zur Herstellung einer Karte mit Mikroschaltung nach einem der Ansprüche 18 bis 20, **dadurch gekennzeichnet, daß** die Mikroschaltung mit den Verbindungsklemmen der Antenne durch den Boden des Hohlraums verbunden wird.

22. Verfahren zur Herstellung einer Karte mit Mikroschaltung nach einem der Ansprüche 18 bis 21, **dadurch gekennzeichnet, daß** die Antenne durch Warm- bzw. Heißprägung angeordnet wird.

23. Verfahren zur Herstellung einer Karte mit Mikroschaltung nach einem der Ansprüche 18 bis 21, **dadurch gekennzeichnet, daß** die Antenne entweder durch eine Ablagerung bzw. Anordnung eines Drahts eines leitenden Materials oder durch Siebdruck einer leitenden Tinte oder eines leitenden bzw. leitfähigen Harzes oder durch Photoätzung oder durch Tampondruck hergestellt wird.

24. Verfahren zur Herstellung einer Karte mit Mikroschaltung nach einem der Ansprüche 18 bis 23, wobei die Strecken des externen Kontakts mit entsprechenden Verbindungsklemmen durch Verbindungsbahnen verbunden werden, **dadurch** gekenntzeichnet, daß die Strecken des externen Kontakts, die Verbindungsklemmen der Strecken des externen Kontakts und die Verbindungsbahnen durch eine Warm- bzw. Heißprägung hergestellt werden.

25. Verfahren zur Herstellung einer Karte mit Mikroschaltung nach einem der Ansprüche 18 bis 24, **dadurch gekennzeichnet, daß** die Mikroschaltung geklebt wird.

26. Verfahren zur Herstellung einer Karte mit Mikroschaltung nach Anspruch 25, **dadurch gekennzeichnet, daß** ein Kleber verwendet wird, welcher ein Schrumpfen während eines Härtens aufweist, um die Mikroschaltung zu kleben, wobei gleichzeitig die elektrischen Kontakte auf Höhe der Verbindungen zwischen der Mikroschaltung einerseits und den Strecken des externen Kontakts und der Antenne andererseits verstärkt werden.

27. Verfahren zur Herstellung einer Karte mit Mikroschaltung nach Anspruch 25 oder 26, **dadurch gekennzeichnet, daß** ein anisotroper Kleber zum Kleben der Mikroschaltung verwendet wird.

28. Verfahren zur Herstellung einer Karte mit Mikroschaltung nach Anspruch 25 oder 26, **dadurch gekennzeichnet, daß** ein isolierender Kleber zum Kleben der Mikroschaltung verwendet wird.

29. Verfahren zur Herstellung einer Karte mit Mikroschaltung nach einem der Ansprüche 18 bis 28, **dadurch gekennzeichnet, daß** leitende bzw. leitfähige Erhebungen auf einer Einheit der Verbindungsenden der Mikroschaltung und/oder auf einer Einheit der Verbindungsklemmen ausgebildet werden.

30. Verfahren zur Herstellung einer Karte mit Mikroschaltung nach Anspruch 29, **dadurch gekennzeichnet, daß** die leitenden Erhebungen durch eine Thermosonic-Verbindung eines metallischen Drahts hergestellt werden.

31. Verfahren zur Herstellung einer Karte mit Mikroschaltung nach Anspruch 29, **dadurch gekennzeichnet, daß** die leitenden Erhebungen durch eine Ablagerung bzw. Anordnung eines leitenden bzw. leitfähigen Klebers hergestellt werden.

32. Verfahren zur Herstellung einer Karte mit Mikroschaltung nach einem der Ansprüche 29 bis 31, **dadurch gekennzeichnet, daß** ein leitender Kleber auf einer Einheit von leitenden Erhebungen und/oder auf einer Einheit von Verbindungsklemmen und/oder auf einer Einheit von Anschlußenden angeordnet wird, um die Mikroschaltung zu kleben.

33. Verfahren zur Herstellung einer Karte mit Mikroschaltung nach einem der Ansprüche 18 bis 32, **dadurch gekennzeichnet, daß** die Antenne und die Strecken des externen Kontakts während desselben Vorgangs hergestellt bzw. ausgebildet werden.
